# EUROPEAN PATENT SPECIFICATION

(11) **EP 1 357 558 B1**
(45) Date of publication and mention of the grant of the patent: **12.07.2006**
(21) Application number: 03009170.6
(22) Date of filing: 22.04.2003
(51) Int. Cl.: G11C 15/04

(54) **Dense content addressable memory cell**
Dichte inhaltsadressierbare Speicherzelle
Cellule de mémoire associative dense

(30) Priority: 22.04.2002 US 127175
(43) Date of publication of application: 29.10.2003
(73) Proprietor: Broadcom Corporation, Irvine, CA 92618-7013 (US)
(72) Inventor: Afghahi, Morteza Cyrus, 92692 Mission Viejo, California (US)
(74) Representative: Jehle, Volker Armin

(56) References cited:
- US-A- 3 609 710
- US-A- 5 475 633
- MIYATAKE H ET AL: "A DESIGN FOR HIGH-SPEED LOW-POWER CMOS FULLY PARALLEL CONTENT-ADDRESSABLE MEMORY MACROS" IEEE JOURNAL OF SOLID-STATE CIRCUITS, IEEE INC. NEW YORK, US, vol. 36, no. 6, June 2001 (2001-06), pages 956-968, XP001068191 ISSN: 0018-9200
- NODA K ET AL: "A 1.9-/spl mu/mloadless CMOS four-transistor SRAM cell in a 0.18-/spl mu/m logic technology" , ELECTRON DEVICES MEETING, 1998. IEDM '98 TECHNICAL DIGEST., INTERNATIONAL SAN FRANCISCO, CA, USA 6-9 DEC. 1998, PISCATAWAY, NJ, USA,IEEE, US, PAGE(S) 643-646 XP010321496 ISBN: 0-7803-4774-9 * figure 1 * * page 644, column 1 *
- GROSSPIETSCH K E: "ASSOCIATIVE PROCESSORS AND MEMORIES: A SURVEY" IEEE MICRO, IEEE INC. NEW YORK, US, vol. 12, no. 3, 1 June 1992 (1992-06-01), pages 12-19, XP000277657 ISSN: 0272-1732
- "HIGH PERFORMANCE STATIC CONTENT ADDRESSABLE MEMORY CELL" IBM TECHNICAL DISCLOSURE BULLETIN, IBM CORP. NEW YORK, US, vol. 32, no. 3A, 1 August 1989 (1989-08-01), pages 478-479, XP000049388 ISSN: 0018-8689

## Description

### BACKGROUND OF THE INVENTION

This invention relates to memory cells and more particularly relates to content addressable memory cells.

Many memory devices store and retrieve data by addressing specific memory locations. As a result, this path often becomes the limiting factor for systems that rely on fast memory access. The time required to find an item stored in memory can be reduced considerably if the stored data item can be identified for access by the content of the data itself rather than by its address. Memory that is accessed in this way is called content-addressable memory (CAM). CAM provides a performance advantage over other memory search algorithms (such as binary and tree-based searches or look-aside tag buffers) by comparing the desired information against the stored data simultaneously, often resulting in an order-of-magnitude reduction of search time.

A CAM cell is the basic circuit determining the speed, size and power consumption of a CAM system. Known CAM cells require a substantial number of transistors that consume power and require a substantial amount ofarea on a chip. In addition, match circuitry employed in known CAM cells requires a substantial amount of time for proper operation. This invention addresses these problems and provides a solution.

A content addressable memory cell according to the preamble of claim 1 is known from document "A design for high-speed low-power CMOS fully parallel content addressable memory macros" of Miyatake H., Tanaka M. and Mori Y, IEEE JOURNAL OF SOLID-STATE CIRCUITS, vol 46, Nr 6, Pages 956-968, ISSN 0018-9200.

Document "A 1.9-µm² loadless CMOS four-transistor SRAM cell in a 0.18µm logic technology" of Noda K. et al, Electron Devices Meeting, 1998. IEDM '98 Technical Digest., ISBN 0-7803-4774-9, discloses a four transistor SRAM cell with two p-channel transfert transistors and two cross-coupled n-channel transistors.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

The content addressable memory cell of the invention is defined by claim 1.

By using the foregoing type of cell, the number of components in the CAM can be reduced and the speed of operation can be increased. In addition, the power consumption of the cell can be reduced.

These and other advantages and novel features of the present invention, as well as details of an illustrated embodiment thereof, will be more fully understood from the following description and drawings.

### BRIEF DESCRIPTION OF THE DRAWING

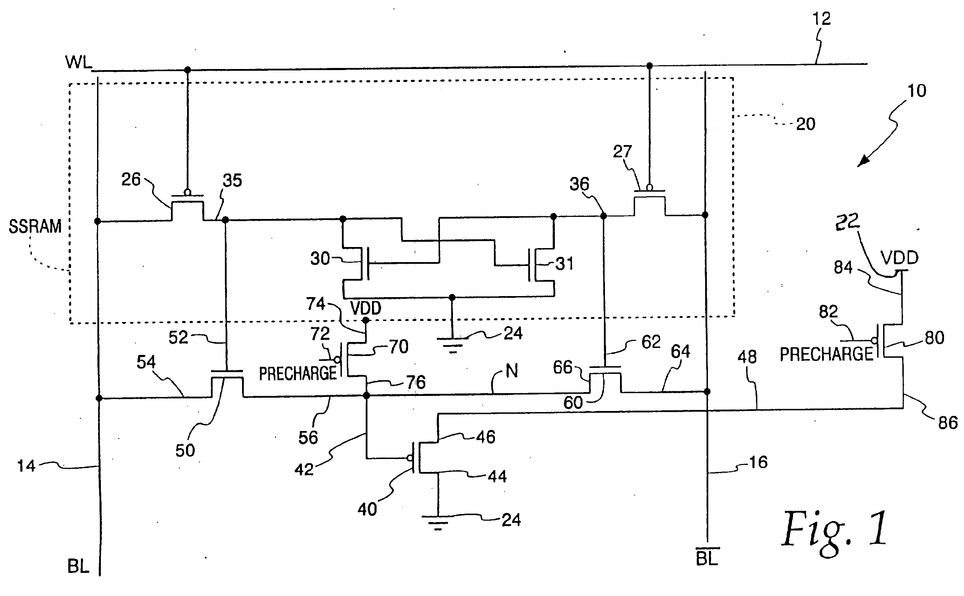

Figure 1 is a schematic diagram of one embodiment of the invention.

### DETAILED DESCRIPTION OF THE INVENTION

Referring to Figure 1, one embodiment of a CAM cell 10 embodying the invention includes a word line 12 and bit lines 14 and 16. Cell 10 includes a semi-static (SSRAM) or dynamic random access memory type circuit 20 including a source 24 of a reference voltage, such as ground potential. Circuit 20 also includes p-channel transistors 26-27 and n-channel transistors 30-31 cross-coupled as shown. Transistors 26-27 serve as both reading and writing transistors also called access and loading transistors. Transistors 26-27 may comprise low voltage threshold transistors in order to compensate for the leakage in circuit 20. To make sure that the leakage through the p-channel transistors compensates for the leakage through the n-channel transistors, the voltage on word line 12 can be adaptively changed for proper operation at all process corners and temperatures. If necessary, line 12 is reduced in voltage below VDD (the supply voltage) so that transistors 26 and 27 are partially conductive, thus allowing current conduction that compensates for leakage by transistors 30 and 31. In addition, p-channel transistors 26-27 are better than n-channel transistors to supply charges at circuit points 35 and 36 to maintain the stored data. Bit lines are kept at VDD (precharged) in a default or a no activity state to provide the charges.

Thus, the embodiment shown in Figure 1 is able to store complementary bits of data with only four transistors, while conventional SRAM cells require six transistors. By using the embodiment shown in Figure 1, substantial area is saved on a chip incorporating the cell shown in Figure 1.

Voltage levels corresponding to stored data bits are stored at points 35-36 of circuit 20. The data bits stored at points 35-36 are complements of each other.

Test bits of data are transmitted on bit lines 14 and 16. The test bits of data also are complements of each other.

A switching p-channel match transistor 40 comprises a gate 42 connected to a node N, a source 44 and a drain 46 that is connected to a word match line 48. An n-channel transistor 50 comprises a gate 52 connected to point 35, a source 54 connected to line 14 and a drain 56 connected to node N as shown. An n-channel transistor 60 comprises a gate 62 connected to point 36, a source 64 connected to line 16 and a drain 66 connected to a node N as shown.

A precharge p-channel transistor 70 comprises a gate 72 connected to a precharge circuit (not shown), a source 74 connected to source of voltage VDD and a drain 76 connected to node N as shown.

Another precharge p-channel transistor 80 comprises a gate 82 connected to a precharge circuit (not shown), a source 84 connected to source 22 of voltage and a drain 86 connected to line 48 as shown.

In each of the foregoing transistors, the source-drain path forms a circuit path.

In the precharge state, both lines 14 and 16 are precharged to a logical one state (e.g., to a voltage near VDD) and node N also is precharged to a logical one state (e.g., to a voltage near VDD) through transistor 70 causing match transistor 40 to be completely cut off. The match line 48 also is precharged to VDD.

In the compare state, one of lines 14 and 16 is driven to a logical zero state (e.g., to a voltage near ground potential). If there is a mismatch between the data stored at points 35-36 and the test data represented by the logical states of lines 14 and 16, node N is switched to a logical zero state, causing transistor 40 to discharge the voltage of match line 48 to a level below a logical one (VDD) state. Transistor 40 does not discharge match line 48 down to zero volts. As a result, power is saved. A sense amplifier (not shown) detects whether the match line 48 has gone below VDD.

For example, a mismatch occurs if a logical one is stored at point 35, a logical zero is stored at point 36, a logical zero is transmitted on line 14 and a logical one is transmitted on line 16. Conversely, a match occurs if a logical one is stored at point 35, a logical zero is stored at point 36, a logical one is transmitted on line 14 and a logical zero is transmitted on line 16.

In case of a match, the gate of transistor 40 stays at VDD, keeping transistor 40 in an off state. The match line then does not discharge through transistor 40; the match line 48 stays at VDD.

While the invention has been described with reference to one or more preferred embodiments, those skilled in the art will understand that changes may be made and equivalents may be substituted without departing from the scope of the invention. In addition, many modifications may be made to adapt a particular step, structure, or material to the teachings of the invention without departing from its scope. Therefore, it is intended that the invention not be limited to the particular embodiment disclosed, but that the invention will include all embodiments falling within the scope of the appended claims.

## Claims

1. A content addressable memory cell (10) comprising:
a word line (12);
a first bit line(14);
a second bit line(16);
a pair of n-channel transistors (30, 31) arranged to store a first bit of data at a first point (35) and a second bit of data that is the complement of the first bit of data at a second point (36), wherein the gates of said transistors are cross-coupled and connected only to the drain of the opposite transistor and thus the first and second points (35, 36) respectively;
a first transistor (26) coupled to the word line (12), the first bit line (14) and the first point (35);
a second transistor (27) coupled to the word line (12), the second bit line (16) and the second point (36);
a p-channel match transistor (40) switchable to a first state in response to a first predetermined relationship between the first and second bits and third and fourth bits, said third and fourth bits being transmitted on the first bit line (14) and the second bit line respectively (16) and switchable to a second state in response to a second predetermined relationship between the first and second bits and the third and fourth bits;
a n-channel, third transistor (50) coupling the first bit line(14), first point (35) and the match transistor (40); and
a n-channel, fourth transistor (60) coupling the second bit line(16), second point (36) and the match transistor (40), and
wherein the match transistor (40) comprises a gate (42) and an output circuit path coupled to a match line (48) wherein the cell (10) further comprises a node (N) interconnecting the gate (42), the third transistor (50) and the fourth transistor (60); and
a second p-channel precharge transistor (80) arranged to precharge the match line (48),
**characterized in that**
the first transistor (26) and the second transistor (27) are p-channel transistors and **in that** the content addressable memory cell (10) further comprises a first p-channel precharge transistor (70) arranged to precharge the node (N), so that the match transistor (40) is cut off.

2. The cell (10) of claim1 wherein each of the first transistor (26) and second transistor (27) comprises a variable threshold transistor

3. The cell (10) of claim 2 wherein each of the variable threshold transistors comprises a low threshold variable threshold transistor.

4. The cell (10) of any of the preceding claims wherein each of the third transistor (50) and fourth transistor (60) comprises an n-channel metal oxide silicon field effect transistor (MOSFET).

5. The cell (10) of any of the preceding claims wherein the match transistor (40) comprises a p-channel MOSFET.

6. The cell (10) of any of the preceding claims wherein the first transistor (26) is arranged to read data from the first point (35) and to write data to the second point (36) and wherein the second transistor (27) is arranged to write data to the first point (35) and to read data from the second point (36).

7. The cell (10) of any of the preceding claims wherein the cell (10) comprises a semi-static cell, whereby chip fabrication area is reduced.

## Patentansprüche

1. Assoziativspeicherzelle (10) mit:
einer Wortleitung (12),
einer ersten Bitleitung (14),
einer zweiten Bitleitung (16),
einem Paar N-Kanal-Transistoren (30, 31), die dafür ausgelegt sind, an einer ersten Stelle (35) ein erstes Datenbit und an einer zweiten Stelle (36) ein zweites Datenbit zu speichern, welches das Komplement des ersten Datenbits ist, wobei die Gate-Anschlüsse der Transistoren miteinander kreuzgekoppelt und nur mit dem Drain-Anschluss des gegenüberliegen Transistors und somit mit der ersten bzw. zweiten Stelle (35, 36) verbunden sind,
einem ersten Transistor (26), der mit der Wortleitung (12), der ersten Bitleitung (14) und der ersten Stelle (35) verbunden ist,
einem zweiten Transistor (27), der mit der Wortleitung (12), der zweiten Bitleitung (16) und der zweiten Stelle (36) verbunden ist,
einem P-Kanal-Anpassungstransistor (P-Kanal-Match-Transistor) (40), der in Antwort auf ein erstes vordefiniertes Verhältnis zwischen dem ersten und dem zweiten Bit sowie dem dritten und dem vierten Bit in einen ersten Zustand geschaltet werden kann, wobei das dritte und das vierte Bit über die erste Bitleitung (14) bzw. die zweite Bitleitung (16) gesendet werden, und in Antwort auf ein zweites vordefiniertes Verhältnis zwischen dem ersten und dem zweiten Bit sowie dem dritten und dem vierten Bit in einen zweiten Zustand geschaltet werden kann,
einem dritten Transistor (50), der ein N-Kanal-Transistor ist und die erste Bitleitung (14), die erste Stelle (35) und den Anpassungstransistor (40) miteinander verbindet, und
einen vierten Transistor (60), der ein N-Kanal-Transistor ist und die zweite Bitleitung (16), die zweite Stelle (36) und den Anpassungstransistor (40) miteinander verbindet, und
wobei der Anpassungstransistor (40) einen Gate-Anschluss (42) und einen Ausgangsschaltungspfad umfasst, der mit einer Anpassungsleitung (48) verbunden ist, wobei die Zelle (10) ferner einen Knoten (N) umfasst, der den Gate-Anschluss (42), den dritten Transistor (50) und den vierten Transistor (60) miteinander verbindet, und
einem zweiten P-Kanal-Vorladetransistor (80), der dafür ausgelegt ist, die Anpassungsleitung (48) vorab aufzuladen,
**dadurch gekennzeichnet, dass** der erste Transistor (26) und der zweite Transistor (27) P-Kanal-Transistoren sind und **dadurch**, dass die Assoziativspeicherzelle (10) ferner einen ersten P-Kanal-Vorladetransistor (70) umfasst, der dafür ausgelegt ist, den Knoten (N) vorab aufzuladen, so dass der Anpassungstransistor (40) abgeschaltet wird.

2. Zelle (10) nach Anspruch 1,
wobei der erste Transistor (26) und der zweite Transistor (27) jeweils einen Transistor mit variablem Schwellenwert umfassen.

3. Zelle (10) nach Anspruch 2,
wobei die Transistoren mit variablem Schwellwert jeweils einen Transistor mit niedrigem, variablem Schwellenwert umfassen.

4. Zelle (10) nach einem der vorhergehenden Ansprüche,
wobei der dritte Transistor (50) und der vierte Transistor (60) jeweils einen N-Kanal-MOS-Feldeffektransistor (MOSFET) umfassen.

5. Zelle (10) nach einem der vorhergehenden Ansprüche,
wobei der Anpassungstransistor (40) einen P-Kanal-MOSFET umfasst.

6. Zelle (10) nach einem der vorhergehenden Ansprüche,
wobei der erste Transistor (26) dafür ausgelegt ist, aus der ersten Stelle (35) Daten zu lesen und in die zweite Stelle (36) Daten zu schreiben, und der zweite Transistor (27) dafür, in die erste Stelle (35) Daten zu schreiben und aus der zweiten Stelle (36) zu lesen.

7. Zelle (10) nach einem der vorhergehenden Ansprüche,
wobei die Zelle (10) eine halbstatische Zelle umfasst, wodurch die Chipherstellungsfläche verringert wird.

## Revendications

1. Cellule de mémoire associative (10) comprenant :
une ligne de mots (12) ;
une première ligne de bits (14) ;
une seconde ligne de bits (16) ;
une paire de transistors à canal N (30, 31) agencée pour stocker un premier bit de données à un premier point (35) et un second bit de données qui est le complément
du premier bit de données à un second point (36), dans laquelle les grilles desdits transistors sont couplées entre elles et connectées uniquement au drain du transistor opposé et donc au premier et second point (35, 36), respectivement ;
un premier transistor (26) couplé à la ligne de mots (12), la première ligne de bits (14) et le premier point (35) ;
un deuxième transistor (27) couplé à la ligne de mots (12), la seconde ligne de bits (16) et le second point (36) ;
un transistor de couplage à canal P (40) pouvant être commuté en un premier état en réponse à une première relation prédéterminée entre les premier et second bits et les troisième et quatrième bits, lesdits troisième et quatrième bits étant transmis sur la première ligne de bits (14) et la seconde ligne de bits (16) respectivement, et pouvant être commuté en un second état en réponse à une seconde relation prédéterminée entre les premier et second bits et les troisième et quatrième bits ;
un troisième transistor à canal N (50) couplant la première ligne de bits (14), le premier point (35) et le transistor de couplage (40) ; et
un quatrième transistor à canal N (60) couplant la seconde ligne de bits (16), le second point (36) et le transistor de couplage (40), et
dans laquelle le transistor de couplage (40) comprend une grille (42) et un chemin de circuit de sortie couplé à une ligne de couplage (48) dans laquelle la cellule (10) comprend en outre un noeud (N) interconnectant la grille (42), le troisième transistor (50) et le quatrième transistor (60) ; et
un second transistor de précharge à canal P (80) agencé pour précharger la ligne de couplage (48),
**caractérisée en ce que**
le premier transistor (26) et le deuxième transistor (27) sont des transistors à canal P et **en ce que** la cellule de mémoire associative (10) comprend en outre un premier transistor de précharge à canal P (70) agencé pour précharger le noeud (N), de façon à ce que le transistor de couplage (40) soit éteint.

2. Cellule (10) selon la revendication 1 dans laquelle chacun du premier transistor (26) et du deuxième transistor (27) comprend un transistor à seuil variable.

3. Cellule (10) selon la revendication 2 dans laquelle chacun des transistors à seuil variable comprend un transistor à seuil variable avec un seuil bas.

4. Cellule (10) selon l'une quelconque des revendications précédentes dans laquelle chacun du troisième transistor (50) et du quatrième transistor (60) comprend un transistor à effet de champ de semi-conducteur d'oxyde de métal (MOSFET).

5. Cellule selon l'une quelconque des revendications précédentes dans laquelle le transistor de couplage (40) comprend un MOSFET à canal P.

6. Cellule (10) selon l'une quelconque des revendications précédentes dans laquelle le premier transistor (26) est agencé pour lire des données depuis le premier point (35) et pour écrire des données vers le second point (36) et dans laquelle le deuxième transistor (27) est agencé pour écrire des données vers le premier point (35) et pour lire des données depuis le second point (36).

7. Cellule (10) selon l'une quelconque des revendications précédentes dans laquelle la cellule (10) comprend une cellule semi-statique, moyennant quoi la zone de fabrication de puce est réduite.
